# EUROPEAN PATENT APPLICATION

(11) **EP 4 625 472 A1**
(43) Date of publication of application: **01.10.2025**
(21) Application number: 24167813.5
(22) Date of filing: 28.03.2024
(51) Int. Cl.: H01L 21/02, H01L 21/18

(54) **METHOD FOR FORMING A TMD LAYER STRUCTURE**

(71) Applicant: Imec VZW, 3001 Leuven (BE)
(72) Inventor: GHOSH, Souvik, 3220 Holsbeek (BE); BREMS, Steven, 3010 Kessel-Lo (BE); SCHRAM, Tom, 1330 Rixensart (BE); LOCKHART DE LA ROSA, Cesar Javier, 3150 Haacht (BE)
(74) Representative: Lind Edlund Kenamets Intellectual Property AB

(57) **Abstract**

In an aspect there is provided a method for forming a TMD layer structure on a target wafer, the method comprising:
forming a layer stack on a growth wafer, comprising:
growing a TMD layer on a growth surface of the growth wafer, the TMD layer having first and second opposing major surfaces,
forming a dielectric layer of a high-k dielectric material on the first major surface of the TMD layer, and
forming an interfacial layer on a major surface of the dielectric layer, wherein the interfacial layer is formed of a metal or a semiconductor, and is configured to induce stress at an interface between the growth wafer and the TMD layer;
bonding the layer stack to the target wafer; and
debonding the growth wafer from the layer stack using a mechanical debonding process wherein the growth wafer is released from the TMD layer.

## Description

### TECHNICAL FIELD

The present invention generally relates to a method for forming a transition metal dichalcogenide layer structure on a target wafer.

### BACKGROUND

In the strive to provide more efficient transistor devices, alternatives to silicon as channel material is the subject of intense research. A promising candidate channel material group are 2D materials in the form of transition metal dichalcogenides (TMDs). A monolayer of TMD is formed of a monolayer of a transition metal M (such as W or Mo) sandwiched between a pair of monolayers of a chalcogen X (such as sulfur or selenide). A TMD may therefore also be termed "MX2". Using TMDs as channel material offers several advantages when compared to traditional three-dimensional bulk materials like silicon. For instance, enabling very thin channel layers (e.g., a few monolayers), high electron mobility, precise thickness control, favorable on-off ratios, to name a few.

A wafer scale transfer layer from a growth wafer (e.g. of sapphire) may employ a carrier wafer that is attached to the TMD layer using a polymeric adhesive. The TMD layer may then be peeled off the growth wafer using the carrier wafer and transferred to a target wafer. The carrier wafer may thereafter be debonded and the adhesive stripped from the TMD layer before proceeding with device fabrication, such as gate stack deposition and source/drain contact formation. A drawback of this approach is however that the adhesive interaction with the TMD material tends to leave insoluble residues on the surface of the TMD layer, which ultimately may worsen device performance.

### SUMMARY

In view of the above, it is an object to provide improved methods for wafer scale transfer of TMD layers, enabling transfer of TMD layers from a growth wafer to a target wafer with preserved TMD material quality and layer integrity. It is further an object to provide methods facilitating forming of heterostructures comprising one or more high quality TMD layers, which furthermore are compatible with existing front-end integration processes and materials. It is further an object to provide methods facilitating forming of TMD layer structures being suitable as starting stacks for device integration, such as for GAA devices comprising one or more TMD channel layers. Additional and alternative objectives may be appreciated from the following.

According to an aspect of the present invention, there is provided a method for forming a TMD layer structure on a target wafer, the method comprising:
forming a layer stack on a growth wafer, comprising:
   growing a TMD layer on a growth surface of the growth wafer, the TMD layer having first and second opposing major surfaces,
   forming a dielectric layer of a high-k dielectric material on the first major surface of the TMD layer, and
   forming an interfacial layer on a major surface of the dielectric layer, wherein the interfacial layer is formed of a metal or a semiconductor, and is configured to induce stress at an interface between the growth wafer and the TMD layer;
bonding the layer stack to the target wafer; and
debonding the growth wafer from the layer stack using a mechanical debonding process wherein the growth wafer is released from the TMD layer.

A stacked TMD layer structure, comprising the layer stack, is thereby formed on the target wafer. According to the method, an interfacial layer is incorporated into the layer stack to induce stress at the growth wafer-TMD layer interface. The interfacial layer may hence be referred to as a stressor layer. The stress may in turn facilitate a mechanical debonding of the layer stack from the growth wafer by ensuring that the debonding occurs at the growth wafer-TMD layer interface. That is, the stress induced at the interface causes the growth wafer to be released from the TMD layer during the mechanical debonding process.

Furthermore, in contrast to conventional stressor layer-aided TMD layer wafer transfer approaches, the interfacial / stressor layer is not formed in direct contact with the TMD layer but on an intermediate dielectric layer. As realized by the inventors, an interfacial layer may be used to efficiently induce stress at the growth wafer-TMD layer interface even in presence of an intermediate dielectric layer. It is contemplated that this demonstrates that is not a requirement to have both physical and chemical interaction between a stressor layer and a TMD layer to facilitate mechanical debonding from a growth wafer. This in turn allows the layer stack, comprising the TMD layer, the dielectric layer and the interfacial layer, to be transferred as a single layer system to the target wafer, directly or using a rigid temporary carrier wafer, while mitigating a risk of formation of cracks or voids.

Since the dielectric layer is formed of a high K dielectric, the dielectric layer may be used in subsequent device integration, to serve as gate dielectric for the TMD layer. The first major surface of the TMD layer may hence be capped by the dielectric layer already from the forming of the layer stack until being incorporated into the final device. This may be especially beneficial in gate-all-around (GAA) device fabrication wherein the TMD layer otherwise would be laid bare and free hanging before being provided with the gate dielectric. This tends to lead to sagging of the TMD layer. For this reason, TMD layer sagging is an accepted defect mode in current GAA device fabrication approaches. According to the present method, the presence of the dielectric layer mitigates a risk of sagging of the TMD layer in GAA device fabrication.

Furthermore, and by virtue of the presence of the dielectric layer, since the interfacial layer is formed of a metal or semiconductor, it may be used in subsequent device integration, to serve as gate material, either gate electrode material (when formed of a metal) or sacrificial gate material (when formed of a semiconductor). The term "metal" is here used in an inclusive sense to encompass also semimetals, such as Bi and Sb. There is hence no need for removing (e.g. peeling off) the interfacial / stressor layer from the TMD layer or the dielectric layer. Where the interfacial layer is a semiconductor, the semiconductor of the interfacial layer may be a 3D semiconductor material or bulk semiconductor material (i.e., a non 2D semiconductor material), such as a Si-, Ge- or SiGe-based material, monocrystalline or polycrystalline (e.g., epitaxial Si, Ge or SiGe).

While each of the dielectric layer and the interfacial layer may be separately formed and then transferred onto the TMD layer by layer transfer techniques, a more scalable and efficient approach may be to deposit the dielectric layer and the interfacial layer on the TMD layer. During deposition of the interfacial layer the dielectric layer may protect the TMD layer from being damaged during the deposition of the interfacial layer. This enables the interfacial layer to be deposited using faster and more cost-efficient techniques, such as sputtering. Meanwhile, deposition processes for high-K dielectrics typically used in an industrial setting are in general relatively benign (e.g. compared to metal sputtering) and the dielectric layer may thus be deposited on the TMD layer without causing damage thereto.

As will be disclosed in further detail in the following, the present method is compatible with both direct wafer transfer approaches and indirect or two-stage wafer transfer approaches involving using of a temporary carrier wafer to transfer the layer stack to the target wafer. In an indirect approach, the interfacial layer and the dielectric layer may additionally protect the TMD layer from being exposed to polymeric adhesives or other bonding materials used for bonding the layer stack to the carrier wafer, which may result in residues deteriorating the quality of the TMD layer. While polymeric residue removal directly from the surface of a TMD layer can deteriorate the electrical properties of the TMD layer, such caustic removal from the surface of the interlayer could potentially have only superficial surface limited oxidative effects, while preserving the overall electric properties of the interfacial layer.

In the following, the label "first" may be used to reference the aforementioned growth wafer, layer stack, channel layer, dielectric layer and interfacial / stressor layer.

In some embodiments, the interfacial layer is formed of Bi, Sb, Ni, Si (e.g., doped Si), Ge (e.g., doped Ge) or SiGe (e.g., doped SiGe).

These materials all provide a sufficient adhesion force to the high-k dielectric layer to allow the layer stack to be mechanically debonded from the growth substrate without use of etching chemistries, grinding, or the like. Moreover, while metals or semimetals such as Bi, Sb or Ni may function as gate electrode material in a gate stack, semiconductors such as Si, Ge or SiGe may present a sufficient etch contrast with respect to the dielectric layer and the TMD layer to allow a selective removal during a replacement metal gate process, e.g. to form a GAA.

In some embodiments, the growth wafer is a sapphire wafer. A sapphire wafer may provide a templated growth surface, allowing high quality TMD growth thereon. In other embodiments, the growth wafer is a GaN wafer.

In some embodiments, the interfacial layer is formed with a thickness in a range of 10 nm or more, such as 50 nm or more, and/or an equivalent oxide thickness of the dielectric layer is 5 nm or less, such as 2 nm or less. The interfacial layer and/or the dielectric layer may thus be engineered to induce an appropriate amount of stress to the TMD layer-growth wafer interface to facilitate the mechanical debonding of the layer stack from the growth wafer. In general, it is contemplated that a thin dielectric layer may allow a greater amount of stress to be transmitted between the interfacial layer and the channel layer. This brings a synergistic advantage to device fabrication, where scaling of the equivalent oxide thickness for the gate dielectric may be desirable.

In some embodiments of an indirect wafer transfer approach, the method comprises bonding the layer stack to a carrier wafer, with the interfacial layer facing the carrier wafer, and thereafter, in sequence: performing the debonding the growth wafer from the layer stack, bonding the layer stack to the target wafer with the TMD layer facing the target wafer, and debonding the carrier wafer from the layer stack. As discussed above, presence of the interfacial layer protects the TMD layer from reacting with the bonding materials (e.g. polymeric adhesives) used for bonding the layer stack to the carrier wafer.

By the indirect wafer transfer approach, the layer stack may thus be transferred and bonded to the target wafer such that the TMD layer is located between the dielectric layer and the target wafer. The interfacial layer will hence form a top layer of the layer stack. The layer stack may thus be used to form a top-gated TMD-channel device.

A method for forming a top-gated TMD-channel device may comprise:
forming the TMD layer structure; and
patterning the TMD layer structure, the patterning comprising:
   patterning a channel layer in the TMD layer, and
   patterning a gate stack in the dielectric layer and the interfacial layer, the gate stack extending along the channel layer; and
forming source/drain contacts in contact with the channel layer.

The gate stack may thus be formed on top of the channel layer. The source/drain contacts may be formed as side contacts or top contacts.

Bonding the layer stack to the carrier wafer may comprise bonding the interfacial layer of the layer stack to the carrier wafer using a bonding layer stack. As discussed above, by the presence of the interfacial layer and the dielectric layer, direct contact between the TMD layer and bonding materials of the bonding layer stack may be avoided. Hence, the type and composition of the bonding layer stack may be chosen with less regard to any risk of reacting with the TMD layer.

For example, the bonding layer stack may comprise a polymeric adhesive layer and a release layer intermediate the carrier wafer and the adhesive layer, wherein bonding the layer stack to the carrier wafer may comprise adhesively attaching an adhesive layer to the interfacial layer, and wherein debonding the layer stack from the carrier wafer may comprise one of laser debonding or photonic debonding. A bonding layer stack based on a polymeric adhesive layer and a release layer enables a rational and scalable realization of the method in an industrial setting.

After debonding the carrier wafer from the layer stack, a cleaning process may be performed to remove remaining adhesive from the interfacial layer. The interfacial layer and the dielectric layer ensures that direct contact between the TMD layer and both adhesive material and cleaning chemistries may be avoided.

In some embodiments of a direct transfer approach, the method comprises bonding the layer stack to the target wafer, with the interfacial layer facing the target wafer, and thereafter debonding the growth wafer from the layer stack.

The layer stack may thus be transferred and bonded to the target wafer such that the interfacial layer is located between the dielectric layer and the target wafer. The interfacial layer will hence form a bottom layer of the layer stack. The layer stack may thus be used to form a back-gated TMD-channel device.

A method for forming a back-gated TMD-channel device may comprise:
forming the TMD layer structure; and
patterning the TMD layer structure, the patterning comprising:
   patterning a channel layer in the TMD layer, and
   patterning a gate stack in the dielectric layer and the interfacial layer, the gate stack extending along the channel layer; and
forming source/drain contacts in contact with the channel layer.

The gate stack may thus be underneath the channel layer. The source/drain contacts may be formed as top contacts.

In some embodiments, after debonding the growth wafer from the layer stack, the method may further comprise forming a second dielectric layer of a high-k dielectric material on the second major surface of the TMD layer. The second major surface of the TMD layer may thus be interfaced with the high-k dielectric material, wherein both opposing major surfaces of the TMD layer may be protected. The method may further proceed with forming a second interfacial layer on a major surface of the second dielectric layer. This enables forming of a device comprising a TMD layer gated from two sides. The layer stack, further provided with the second dielectric and interfacial layers is moreover suitable as a starting structure for stacking additional such layer stacks on top of the layer stack, to form a TMD layer structure with two or more TMD layers, as will be further described below.

In some embodiments, the second interfacial layer is formed as a first interfacial sub-layer on the major surface of the second dielectric layer, and the method further comprises:
forming on a second growth wafer a second layer stack, comprising:
   growing a second TMD layer on a growth surface of the second growth wafer, the second TMD layer having first and second opposing major surfaces,
   forming a third dielectric layer of a high-k dielectric material on the first major surface of the second TMD layer, and
   forming a second interfacial sub-layer on a major surface of the third dielectric layer;
bonding the second layer stack to the first layer stack such that the first and second interfacial sub-layers are directly bonded to each other to form a common second interfacial layer configured to induce stress at an interface between the second growth wafer and the second TMD layer; and
thereafter debonding the second growth wafer from the second layer stack using a mechanical debonding process wherein the second growth wafer is released from the second TMD layer.

A second layer stack, corresponding to the first layer stack, may thus be stacked upon and bonded to the first layer stack. An extended TMD layer structure may thus be formed, comprising two stacked TMD layers, separated by a sub-stack of the second interfacial layer sandwiched between the second and third dielectric layers.

The method may further comprise, after debonding the second growth wafer from the second layer stack, forming a fourth dielectric layer of a high-k dielectric material on the second major surface of the second TMD layer, and optionally, forming a third interfacial layer on a major surface of the fourth dielectric layer. The second TMD layer may thus be sandwiched between two dielectric-interfacial layer pairs.

The TMD layer structure may be further extended by repeatedly stacking and bonding further layer stacks on top of the second layer stack. More specifically, in some embodiments, the third interfacial layer forms a third interfacial sub-layer on the major surface of the fourth dielectric layer, and the method further comprises:
forming on a third growth wafer a second layer stack, comprising:
   growing a third TMD layer on a growth surface of the third growth wafer, the third TMD layer having first and second opposing major surfaces,
   forming a fifth dielectric layer of a high-k dielectric material on the first major surface of the second TMD layer, and
   forming a fourth interfacial sub-layer on a major surface of the fifth dielectric layer;
bonding the third layer stack to the second layer stack such that the third and fourth interfacial sub-layers are directly bonded to each other to form a common third interfacial layer configured to induce stress at an interface between the third growth wafer and the third TMD layer; and
thereafter debonding the third growth wafer from the third layer stack using a mechanical debonding process wherein the third growth wafer is released from the third TMD layer.

A further extended TMD layer structure comprising three TMD layers may thus be formed.

The method may further comprise, after debonding the third growth wafer from the third layer stack, forming a sixth dielectric layer of a high-k dielectric material on the second major surface of the third TMD layer, and optionally, forming a fourth interfacial layer on a major surface of the sixth dielectric layer.

A further extended TMD layer structure comprising three TMD layers, each sandwiched between two respective dielectric-interfacial layer pairs may thus be formed.

In some embodiments, the method further comprises processing edges of the TMD layer structure, comprising at least the first layer stack and the target wafer, and optionally the second layer stack, and optionally the third layer stack, using an edge bead removal process, and subsequently depositing the high-k dielectric material on the TMD layer structure and along the processed edges. The edges of the TMD layer structure may thus be cleaned prior to further fabrication steps, such as device fabrication. Further, the high k dielectric material may surround the TMD layer(s) of the TMD layer structure and mitigate stress. As may be appreciated, depending on at what stage the high k dielectric material is deposited, the high k dielectric material may form the second, fourth or sixth dielectric layer.

### BRIEF DESCRIPTION OF THE DRAWINGS

This and other aspects of the present disclosure will now be described in more detail, with reference to example embodiments and the appended drawings.
Fig. 1a-f schematically illustrate a first method for forming a TMD layer structure on a target wafer.
Fig. 2a-b schematically illustrate a variation of the first method.
Fig. 3a-d schematically illustrate a second method for forming a TMD layer structure on a target wafer.
Fig. 4a-c schematically illustrate a variation of the second method.
Fig. 5a-i schematically illustrate a third method for forming a TMD layer structure on a target wafer.
Fig. 6a-c schematically illustrate process steps which may be used for mitigating stress in a TMD layer structure.
Fig. 7a-c schematically illustrate a method for forming a device using a TMD layer structure formed in accordance with the first method.
Fig. 8a-c schematically illustrate a method for forming a device using a TMD layer structure formed in accordance with the second method.

### DETAILED DESCRIPTION

The present disclosure provides methods facilitating wafer-scale transfer of high material quality TMD layers from a growth wafer to a target wafer. The methods are facilitated by a combination of high-k dielectric material layer and an interfacial layer, where the interfacial layer is configured to function as a stressor layer during debonding from the growth wafer. This allows the TMD/high-K/interfacial layer stack to be transferred as a single layer unit or layer system, as may be more fully appreciated from the following detailed description.

It is to be noted that when an element herein is referred to as being "on a major surface" of another element, as in a first layer formed on a major surface of a second layer, means that the element (e.g. first layer) is formed/arranged directly on, i.e. on and in direct contact or abutting, the major surface of the other element (e.g. second layer). It is further to be noted that when an element (e.g. a layer or other structure) is referred to as being "on" another element, it can be directly on the other element or on one or more intermediate elements on the other element. Conversely, when an element is referred to as being "directly on" another element, there is no intermediate element and the element is thus formed in physical contact or abutment with the other element. It is further to be noted that terms such as "first" and "second" etc. with reference to elements (e.g. layers or other structures) or, as the case may be, process steps are used herein only as labels to facilitate distinguishing between different elements, and need not necessarily imply that such elements or process steps are arranged or performed in that particular order, unless stated otherwise.

The drawings are only schematic and the relative dimensions of illustrated elements, such as layers or other structures, may be exaggerated and not drawn to scale. Rather the dimensions may be adapted for illustrational clarity and to facilitate understanding.

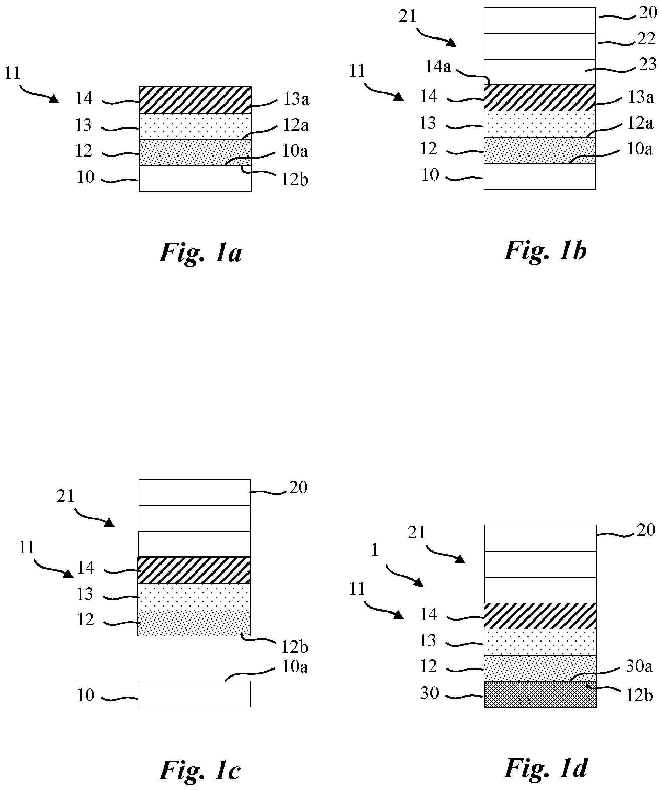

Fig. 1a-f schematically illustrate a first method for forming a TMD layer structure on a target wafer in accordance with an indirect wafer transfer approach employing an intermediate carrier wafer.

With reference to Fig. 1a, there is shown a layer stack 11 formed on a growth wafer 10. The depicted structure represents an initial or starting structure for forming a TMD layer structure on a target wafer, as will be disclosed in the following.

The layer stack 11 comprises a TMD layer 12 grown on a growth surface 10a of the growth wafer 10, a dielectric layer 13 of a high-k dielectric material formed on a first major surface 12a of the TMD layer 12, and an interfacial layer 14 formed on a major surface 13a of the dielectric layer 13.

The growth wafer 10 may for example be a sapphire wafer. However, also other types of growth wafers, such as growth wafers providing a templated growth surface for the TMD layer 12, may be used. The growth wafer 10 may by way of example be a 300 mm wafer, however also growth wafers of smaller sizes are possible, such as 100 mm wafers.

The TMD layer 12 may for example be formed of MoS₂, MoSe₂, WS₂ or WSe₂. The TMD layer 12 may be grown on the growth wafer 10 using any suitable deposition process, such as chemical vapor deposition (CVD) or physical vapor deposition (PVD). Deposition processes for growing high quality TMD layers on a templated wafer, such as a sapphire surface, are per se known in the art and will therefore not be further detailed herein. The TMD layer 12 may be formed with a thickness of one to a few TMD monolayers, e.g. corresponding to a thickness in a range of a few tenths of a nanometer to a few nanometers.

The dielectric layer 13 may be formed by depositing the high-k dielectric material on the first major surface 12a of the TMD layer 12. The high-k dielectric material may comprise an oxide such as HfO₂, HfSiO, LaO, AIO, or ZrO, or some other suitable high-k dielectric which may be deposited without damaging the TMD layer 12. Multi-layered compositions are also possible, such as a dielectric layer formed of a first sub-layer of a first material and a second sub-layer of a second material. The high-k dielectric material may for example be deposited conformally, e.g. by atomic layer deposition (ALD) or CVD, and may be deposited by ALD. The dielectric layer 13 may for example be formed with an equivalent oxide thickness of 5 nm or less, such as 2 nm or less. This thickness range may render the dielectric layer 13 suitable for use as a gate dielectric in a TMD-channel device which may be formed using the finished TMD layer structure.

The interfacial layer 14 is configured as a stressor layer for inducing stress at an interface between the growth wafer 10 and the TMD layer 12, to facilitate a subsequent debonding step further discussed below. The interfacial layer 14 may be formed by depositing a metal or semiconductor material on the major surface 13a of the dielectric layer 13. Example metals for the interfacial layer 14 which may function as a stressor include Bi, Sb and Ni. Also semiconductor materials are possible, such as (doped) Si, SiGe or Ge. A metal or semiconductor stressor material may be deposited using any suitable deposition process, such as CVD, PVD or ALD. A metal stressor material may further be deposited by PVD. A semiconductor stressor material may be deposited in crystalline or amorphous form. The interfacial layer 14, metal or semiconductor, may be formed with a thickness of 10 nm or more, such as 50 nm or more.

In Fig. 1b, the layer stack 11, with the growth wafer 10, has been bonded to a carrier wafer 20, with the interfacial layer 14 facing the carrier wafer 20.

The layer stack 11 and the carrier wafer 20 may as shown be bonded to each other using a bonding layer stack 21 comprising a polymeric adhesive layer 23 and a release layer 22 intermediate the carrier wafer 20 and the adhesive layer 23. The carrier wafer 20 may thus be adhesively attached to a major surface 14a of the interfacial layer 14 via the adhesive layer 23. The carrier wafer 20 may for example be a glass wafer. A glass wafer may facilitate a subsequent laser or photonic debonding process, further discussed below. The release layer 22 may be a laser release layer (e.g. polymer-based) or a metal layer for absorbing light of a photonic broadband light source.

In Fig. 1c, the growth wafer 10 has been debonded from the layer stack 11 using a mechanical debonding process. By suitable engineering of the interfacial layer 14, the interfacial layer 14 may be configured to induce stress at the interface between the TMD layer 12 and the growth wafer 10 such that the bonding force between the growth surface 10a and the second major surface 12b of the TMD layer 12 becomes smaller than the bonding force between the carrier wafer 20 and the interfacial layer 14 (i.e. conferred by the bonding layer stack 21). The debonding may thus occur between the TMD layer 12 and the growth wafer 10.

To further reduce the bonding force between the TMD layer 12 and the growth wafer 10, and thus facilitate a mechanical debonding, the interface between the TMD layer 12 and the growth wafer 10 may be intercalated by water (e.g. de-ionized water or ultra-pure water to mitigate a risk of contaminating the TMD layer 12). Water may for example be intercalated by subjecting the TMD layer 12 and the growth wafer 10 to a water treatment, e.g. comprising soaking the TMD layer 12 and the growth wafer 10 in water for a duration sufficient for allowing intercalated water to form along a sufficient area of the interface. As may be appreciated by the skilled person, the duration for this to occur may be dependent on factors such as the dimensions of the interface, the particular composition of the water and the temperature of the water. The water treatment may be performed prior to forming the dielectric layer 13 on the TMD layer 12, to avoid intercalation between other layers of the layer stack 11.

In Fig. 1d, the layer stack 11, bonded to the carrier wafer 20, has been transferred and bonded to a target wafer 30, with the TMD layer 12, more specifically its second major surface 12b, facing the target wafer 30. The bonding may be achieved using any suitable bonding process, such as a dry bonding or vacuum bonding. Further examples include oxide-oxide bonding or nitride-nitride bonding, e.g. by depositing an oxide or nitride bonding layer on the second major surface 12b of the TMD layer 12 and bonding it to a corresponding oxide or nitride bonding layer formed on the target wafer 30.

The target wafer 30 may be a conventional wafer or substrate, suitable for semiconductor device processing. The target wafer 30 may for instance be formed of Si, a Ge substrate or SiGe. Other non-limiting examples include a silicon-on-insulator (SOI) substrate, a GeOI substrate or a SiGeOI substrate, a III-V substrate, as well as a BEOL process substrate with exposed BEOL metals.

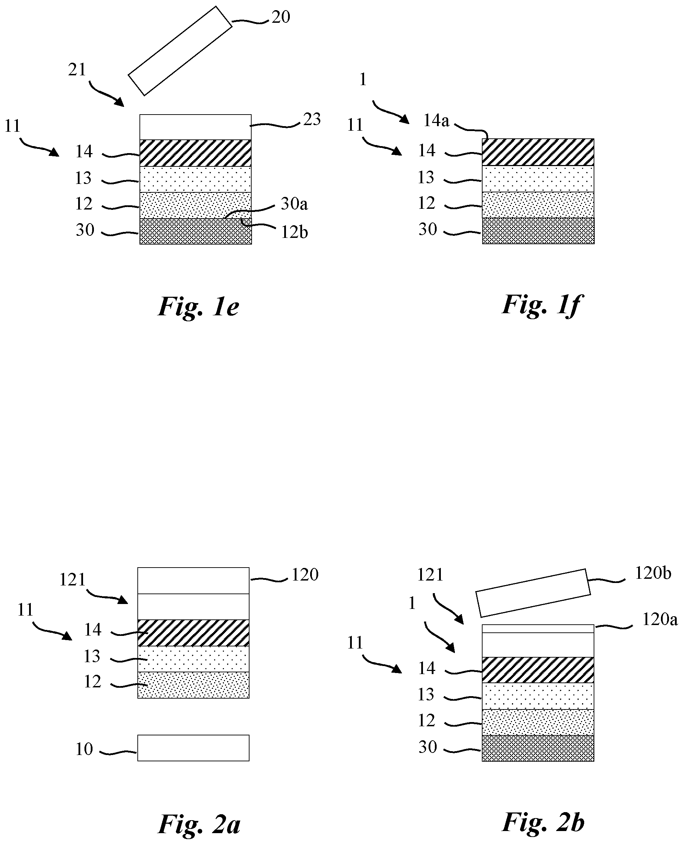

In Fig. 1e, the carrier wafer 20 has been debonded from the layer stack 11. In the illustrated example, the release layer 22 is a laser release layer wherein the carrier wafer 20 has been debonded using a laser debonding process consuming the laser release layer 22. Employing a metal release layer 22 and a photonic debonding process, the carrier wafer 20 may instead be debonded from the adhesive layer 23 together with the release layer 22.

Subsequent to the debonding process, the layer stack 11, bonded to the target wafer 30, may further be subjected to a cleaning process to remove any remaining adhesive from the major surface 14a of the interfacial layer 14. Any suitable chemical and/or mechanical adhesive removal process may be used.

Fig. 1f shows the resulting TMD layer structure 1, comprising the layer stack 11 on the target wafer 30 and comprising the TMD layer 12, the dielectric layer 13 and the interfacial layer 14.

Fig. 2a-b schematically illustrate a variation of the first method wherein a carrier wafer 120 being a semiconductor wafer, e.g. an ion-implanted Si wafer, is bonded to the layer stack 11 by an oxide-oxide or a nitride-nitride bonding layer stack 121. After bonding the carrier wafer 120 to the layer stack 11, the layer stack 11 is, as described above, debonded from the growth wafer 10 by a mechanical debonding process (optionally aided by intercalated water). Fig. 2b schematically depict the subsequent debonding of the carrier wafer 120 from the layer stack 11 using e.g. an IR release. As illustrated, an initial step of the debonding may result in release of a thickness portion 120b of the carrier wafer 120. A remaining thickness portion 120a of the carrier wafer 120, as well as the bonding layer stack 121 may be subsequently removed e.g. by grinding or chemical mechanical polishing (CMP), to reveal the interfacial layer 14 of the resulting TMD layer structure 1.

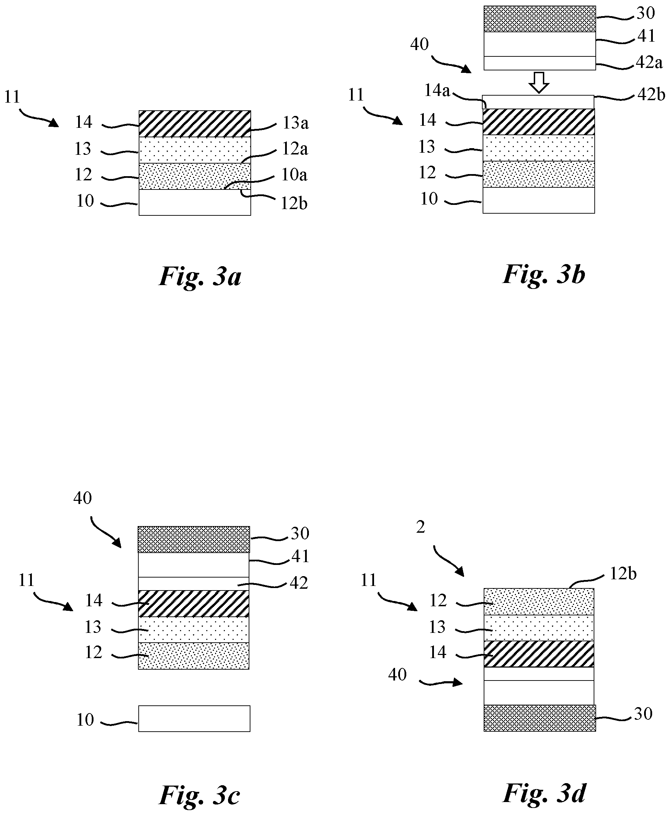

Fig. 3a-d schematically illustrate a second method for forming a TMD layer structure on a target wafer in accordance with a direct wafer transfer approach.

Fig. 3a depicts a layer stack 11 on a growth wafer 10. The discussion of the layer stack 11 and the growth wafer 10 in connection with Fig. 1a applies correspondingly to the layer stack 11 and growth wafer 10 of Fig. 3a.

Fig. 3b shows how the layer stack 11 is being transferred and bonded to a target wafer 30, with the interfacial layer 14, more specifically its major surface 14a, facing the target wafer 30. The target wafer 30 may be of the same type as the target wafer 30 discussed in relation to Fig. 1d. The bonding may in accordance with the illustrated example be achieved by a bonding layer stack 40 comprising metal layers 43a, 43b sputtered on the major surface 14a of the interfacial layer 14 and an insulating layer 41 (e.g., an oxide such as silicon oxide) of the bonding layer stack 40, deposited on the target wafer 30. The bonding may more generally be achieved using any suitable bonding process, such as atomic diffusion bonding, high vacuum surface activated bonding, dry bonding or vacuum bonding. Further examples include oxide-oxide or nitride-nitride bonding.

In Fig. 3c the growth wafer 10 has been debonded from the layer stack 11 using a mechanical debonding process, optionally aided by intercalated water. Analogous to the discussion of the interfacial layer 14 in relation to Fig. 1c, the interfacial layer 14 may, by suitable engineering, be configured to induce stress at the interface between the TMD layer 12 and the growth wafer 10 such that the bonding force therebetween becomes smaller than the bonding force between the target wafer 30 and the interfacial layer 14 (i.e. conferred by the bonding layer stack 40). The debonding may thus occur between the TMD layer 12 and the growth wafer 10.

Fig. 3d shows the resulting TMD layer structure 2 after the debonding process, comprising the layer stack 11 bonded to the target wafer 30. The TMD layer structure 2 has been flipped such that the layer stack 11 is oriented with the layer stack 11 on top of the target wafer 30. The second major surface 12b of the TMD layer 12 thus defines a top surface of the TMD layer structure 2.

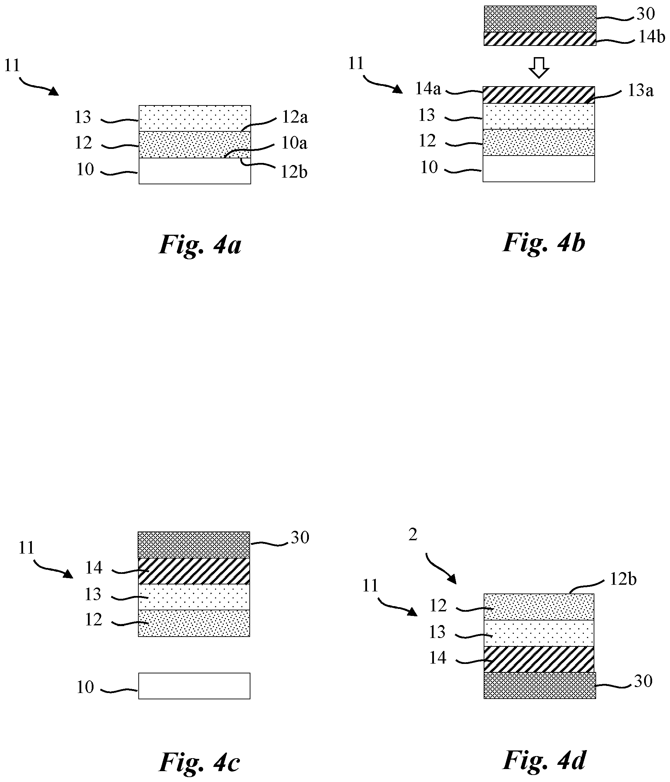

Fig. 4a-d, schematically illustrate a variation of the second method shown in Fig. 3a-d, wherein the layer stack 11 is directly bonded to the target wafer 30 by the interfacial layer 14. After forming the dielectric layer 13 on the first major surface 12a of the TMD layer 12, respective interfacial sub-layers 14a, 14b are formed on the major surface 13a of the dielectric layer 13 and on the target substrate 30 and then bonded to each other face-to-face to achieve the bonding of the layer stack 11 to the target wafer 30. The bonding may be achieved using any suitable bonding process, such as a dry bonding or vacuum bonding. The face-to-face bonding of the interfacial sub-layers 14a, 14b further completes the formation of a common interfacial layer 14. The interfacial sub-layers 14a, 14b may each be deposited on the respective surfaces of the dielectric layer 13 and the target wafer 30, e.g. using any of the deposition techniques exemplified above for the interfacial layer 14. A combined thickness of the interfacial sub-layers 14a, 14b should be such that the final interfacial layer 14 induces a suitable amount of stress at the interface between the growth wafer 10 and the TMD layer 12 to enable the mechanical debonding process.

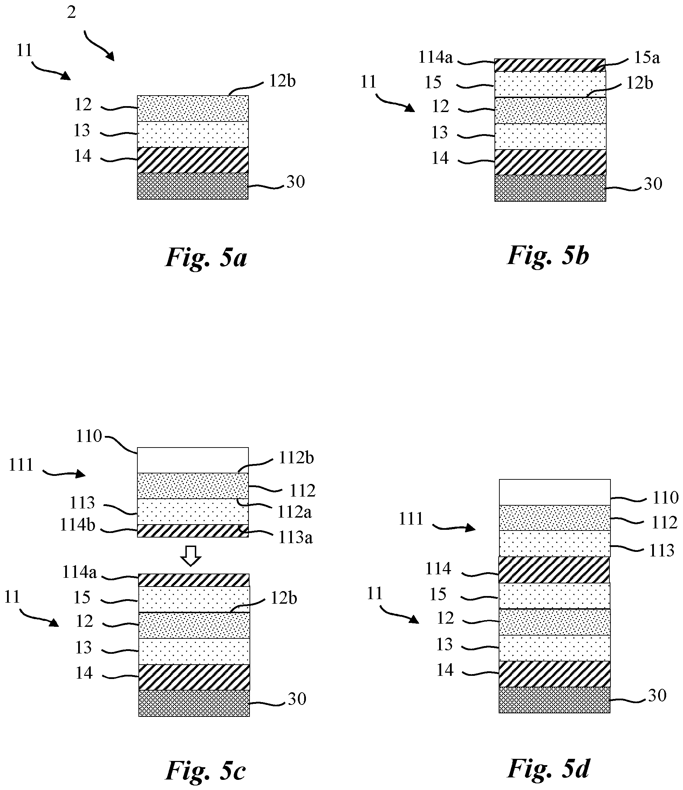

The TMD layer structure 2 as shown in Fig. 3d and 4d are suitable as starting structures for forming extended TMD layer structures comprising further TMD layers. A method for forming such an extended TMD layer structure on a target wafer 30 will now be described with reference to Fig. 5a-i.

The method will be described in relation to an initial TMD layer structure 2 shown in Fig. 5a and formed in accordance with the method of Fig. 4a-d and corresponding to the stage where the growth wafer 10 has been debonded from the layer stack 11 to expose the second major surface 12b of the TMD layer 12. The method may however equally well proceed from the TMD layer structure 2 formed in accordance with the method of Fig. 3a-d.

In Fig. 5b, a second dielectric layer 15 of a high-k dielectric material, typically the same high-k dielectric material as of the first dielectric layer 13, has been formed on the second major surface 12b of the TMD layer 12. Additionally, a first interfacial sub-layer 114a has been formed on a major surface 15a of the second dielectric layer 15.

In Fig. 5c, there is shown a second layer stack 111 formed on a second growth wafer 110. The second growth wafer 110 may be of a same type as the first growth wafer 10. The second layer stack 111 may be formed by growing a second TMD layer 112 on a growth surface of the second growth wafer 110, forming a third dielectric layer 113 of a high-k dielectric material on a first major surface 112a of the second TMD layer 112, and forming a second interfacial sub-layer 114b on a major surface 113a of the third dielectric layer 113.

The second TMD layer 112 may be grown on the growth surface of the growth substrate 110, e.g. using any of the deposition techniques exemplified above for the first TMD layer 12.

The second and third dielectric layers 15, 113 may each be deposited on the respective major surfaces 12b, 112a of the TMD layers 12, 112, e.g. using any of the deposition techniques exemplified above for the first dielectric layer 13.

The first and second interfacial sub-layers 114a, 114b may each be deposited on the respective surfaces of the dielectric layer 13 and the target wafer 30, e.g. using any of the deposition techniques exemplified above for the interfacial layer 14. In particular, the first and second interfacial sub-layers 114, 114b may be either pre-deposited, or deposited in-situ with the bonding tool used in the following bonding step, on the respective major surfaces 15a, 113a of the second and third dielectric layers 15, 113, and thereafter bonded to each other face-to-face.

In Fig. 5d, the second layer stack 111 has been bonded to the first layer stack 10 such that the first and second interfacial sub-layers 114a, 114b are directly bonded to each other to form a common second interfacial layer 114.

The bonding of the interfacial sub-layers 114a, 114b may be achieved using any suitable bonding process, such as a dry bonding or vacuum bonding. In case of pre-depositing the first and second interfacial sub-layers 114, 114b, the bonding may be preceded with PVD, or low temperature CVD or ALD of the first and second interfacial sub-layers 114, 114b, e.g. using an inert gas such as Ar.

The face-to-face bonding of the interfacial sub-layers 114a, 114b further completes the formation of a common second interfacial layer 114. The second interfacial layer 114 is configured to induce stress at the interface between the second growth wafer 110 and the second TMD layer 112. Analogous to the discussion of the interfacial sub-layers 14a, 14b, a combined thickness of the interfacial sub-layers 114a, 114b should be such that the common interfacial layer 114 induces a suitable amount of stress at the interface between the second growth wafer 110 and the second TMD layer 112 to enable the mechanical debonding process which will follow.

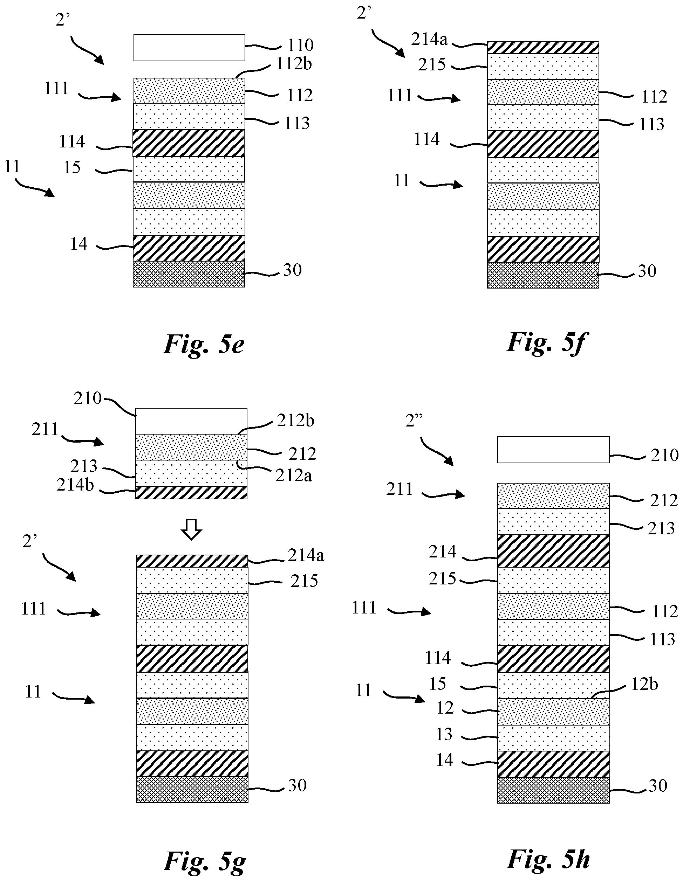

In Fig. 5e, the second growth wafer 110 has been debonded from the second layer stack 111 using a mechanical debonding process, optionally aided by intercalated water, wherein the second growth wafer 110 is released from the second TMD layer 112, more specifically from its second major surface 112b.

Analogous to the discussion of the interfacial layer 14 in relation to Fig. 1c, the second interfacial layer 114 may be configured to induce stress at the interface between the second TMD layer 112 and the second growth wafer 110 such that the bonding force therebetween becomes smaller than the bonding force between the target wafer 30 and the interfacial layer 14. Naturally, the bonding force between the second TMD layer 112 and the second growth wafer 110 should also be smaller than the bonding forces between each interfacing layer pair of the first and second layer stacks 11, 111.

As shown in Fig. 5e, an extended TMD layer structure 2' comprising first and second stacked TMD layers 12, 112 has thus been formed on the target wafer 30.

Fig. 5f-i further shows how a further extended TMD layer structure 2" can be formed on the target wafer 30 by substantially repeating the process steps of Fig. 5b-d on the TMD layer structure 2'.

In Fig. Sf, a fourth dielectric layer 215 of a high-k dielectric material has been formed on the second major surface 112b of the second TMD layer 112, and a third interfacial sub-layer 214a has been formed on a major surface of the fourth dielectric layer 215.

Fig. 5g further shows a third layer stack 211 formed on a third growth wafer 210 which is about to be bonded to the second layer stack 111 of the TMD layer structure 2'. The third layer stack 211 comprises a third TMD layer 212 grown on a growth surface of the third growth wafer 210, a fifth dielectric layer 213 of a high-k dielectric material formed on a first major surface 212a of the third TMD layer 212, and a fourth interfacial sub-layer 214b formed on a major surface of the fifth dielectric layer 213.

In Fig. 5h the third layer stack 211 has been bonded to the second layer stack 111 such that the third and fourth interfacial sub-layers 214a, 214b are directly bonded to each other to form a common third interfacial layer 214. Subsequently, the third growth wafer 210 has been debonded from the third layer stack 211 using a mechanical debonding process. The discussion of the debonding process in relation to the first and second growth wafers 10, 110 applies correspondingly to the debonding of the third growth wafer 210. Further, the third interfacial layer 214 is, analogous to the first and second interfacial layers 14, 114, configured to induce stress at an interface between the third growth wafer 210 and the third TMD layer 212 to facilitate the mechanical debonding process such that the debonding occurs at the interface between the third growth wafer 210 and the third TMD layer 212. The third growth wafer 210 may thus be released from the resulting further extended TMD layer structure 2" formed on the target wafer 30.

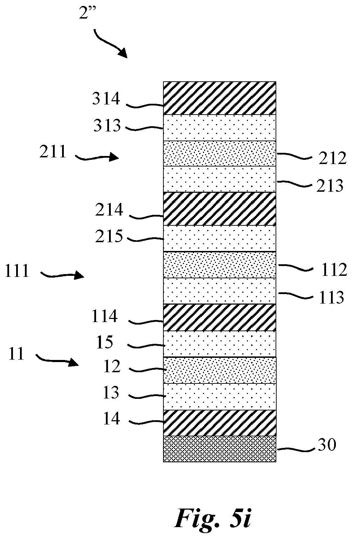

As shown in Fig. 5i, the method may thereafter proceed with forming a sixth dielectric layer 313 of a high-k dielectric material (corresponding to the dielectric layer 215) on the second major surface 212b of the third TMD layer 212, and optionally, forming a fourth interfacial layer 314 on a major surface of the sixth dielectric layer 313. In Fig. 5i, the fourth interfacial layer 314 is shown to be formed with a thickness corresponding to the first through third interfacial layers 14, 114, 214. This may be appropriate in case the TMD layer structure 2" defines the final structure to be used for device integration, and hence no additional layer stacks are to be added. However, it is also possible to form the fourth interfacial layer 314 as a further fifth interfacial sub-layer, to be bonded to a corresponding sixth interfacial sub-layer of a further fourth layer stack corresponding to the third layer stack 211. In fact, these processing steps may be repeated any number of times to obtain a TMD layer structure with a desired number of TMD layers.

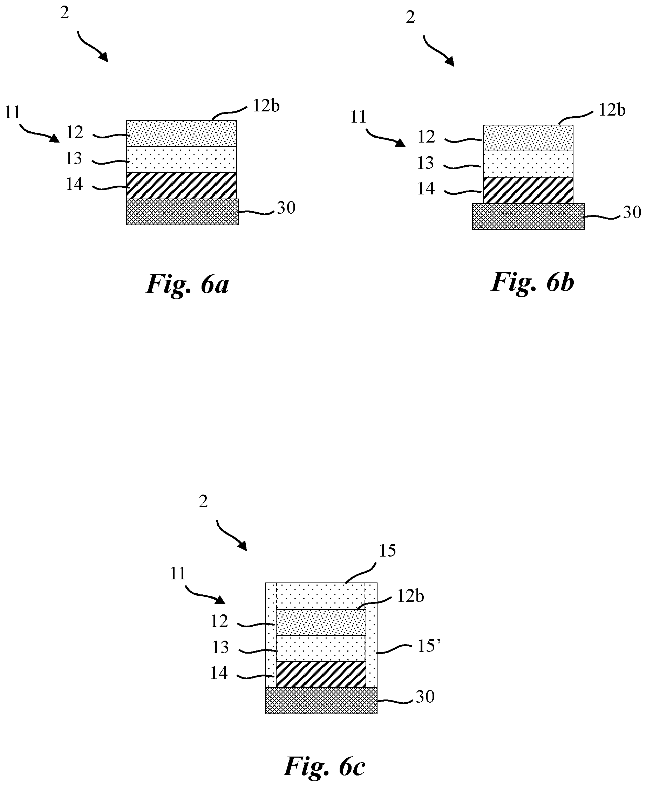

Fig. 6a-c schematically illustrate process steps which may be used for mitigating stress in a TMD layer structure.

The method will be described in relation to a TMD layer structure 2 shown in Fig. 6a and formed in accordance with the method of Fig. 4a-d. The depicted structure 2 thus corresponds to the stage where the growth wafer 10 has been debonded from the layer stack 11 to expose the second major surface 12b of the TMD layer 12. The method may however equally well proceed from the TMD layer structure 2 formed in accordance with the method of Fig. 3a-d.

Fig. 6b shows the TMD layer structure 2 after the edges of the first layer stack 11 and the target wafer 30 have been processed using an edge bead removal process.

Subsequently, as shown in Fig. 6c, a second dielectric layer 15 of a high-k material has been deposited on the second major surface 12b and along the processed edges of the first layer stack 11. The second dielectric layer 15 thus comprises side portions 15' extending along and covering the processed edges of each of the TMD layer 12, the first dielectric layer 13 and the interfacial layer 14. As shown, the second dielectric layer 15 thus joins the first dielectric layer such that the TMD layer 12 is fully encapsulated by the high-k dielectric material. The second dielectric layer 15 shown in Fig. 6a corresponds to the second dielectric layer 15 shown in Fig. 5b and the difference lies mainly in that the edge bead removal process has been performed prior to the high-k dielectric material deposition.

The high-k encapsulation may provide a mechanical support to the TMD layer 12 such that the stress induced in the TMD layer 12 by the interfacial layer 14 is reduced. While this may be useful already when forming a TMD layer structure comprising a single TMD layer 12, the high-k encapsulation may be especially useful for controlling a total amount of stress introduced when forming an extended TMD layer structure such as 2' or 2" described above with reference to Fig. 5a-i. A risk of the repeated stacking of the layer stacks 11, 111, 211 resulting in deformation (e.g. cracks of bowing) of the target wafer 30 and the resulting TMD layer structure 2' or 2" may thus be mitigated. This stress mitigation approach may be applied each time, or at any time, a respective layer stack (e.g. the first layer stack 11, the second layer stack 111 or third layer stack 211) has been bonded to the target wafer 30 and the associated growth wafer 10, 110, 210 has been debonded therefrom.

The various TMD layer structures described above may be used as a starting stack for device integration.

Employing an indirect wafer transfer approach (e.g. as shown in Fig. 1a-f or 2a-b) the interfacial layer of the layer stack will form a top layer of the layer stack and the TMD layer structure. The TMD layer structure may thus be used to form a top-gated TMD-channel device. More specifically, a device may be formed by, after debonding the carrier wafer from the layer stack, patterning the layer stack, the patterning comprising: patterning a channel layer in the TMD layer and patterning a gate stack in the dielectric layer and the interfacial layer, the gate stack extending along the channel layer. Source/drain contacts may subsequently be formed in contact with the channel layer.

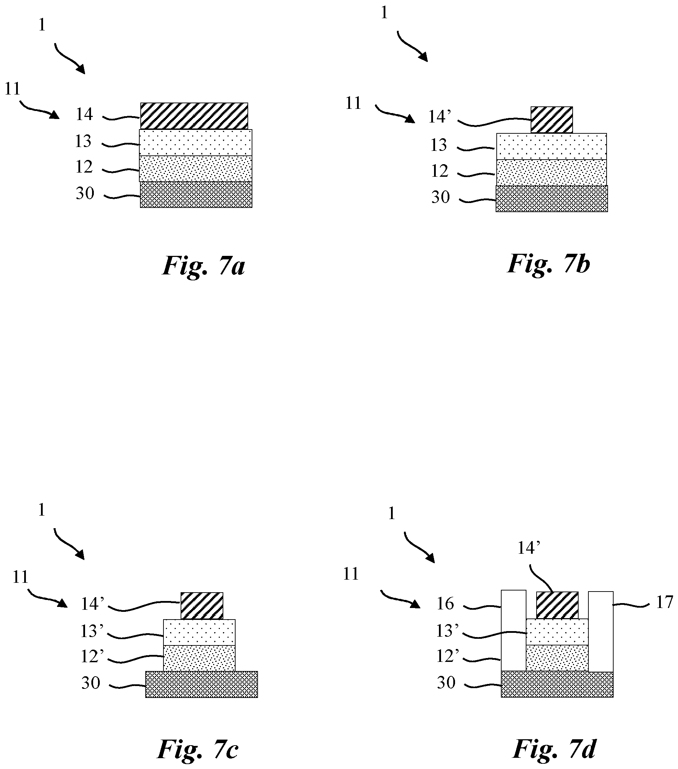

Fig. 7a-d illustrate an example method for forming a top-gated TMD-channel transistor device using a TMD layer structure formed using the indirect wafer transfer approach, such as the TMD layer structure 1.

Fig. 7a shows the TMD layer structure 1 comprising the layer stack 11 bonded to the target wafer 30 with the TMD layer 12 facing the target wafer 30.

Forming the interfacial layer 14 of any of the above-mentioned example metals (e.g. Bi or Sb) or example semiconductors (e.g. Si, SiGe or Ge), allows a gate layer 14' to be patterned in the interfacial layer 14, as shown in Fig. 7b. In case the interfacial layer 14 is formed of a metal, the gate layer 14' may define a gate metal or gate electrode layer. In case the interfacial layer 14 is formed of a semiconductor the gate layer 14' may define a sacrificial gate layer. A sacrificial gate layer may be replaced with a final gate metal or electrode layer, e.g. after source/drain contact formation, using a replacement metal gate process.

In Fig. 7c, the layer stack 11 has been further patterned by patterning a channel layer 12' in the TMD layer 12 and a gate dielectric layer 13' in the dielectric layer 13. A gate stack comprising the gate layer 14' and the gate dielectric layer 13' has thus been formed on top of the channel layer 12', e.g. extending along a channel region of the channel layer 12'.

In Fig. 7d, source and drain contacts 16, 17 have been formed in contact with the channel layer 12', on either side of the channel region. The source and drain contacts 16, 17 may as shown be formed as side contacts, contacting opposite ends of the channel layer 12'. The source and drain contacts 16, 17 may also be formed as top contacts, contacting the first major surface of the channel layer 12' (i.e. corresponding to the first major surface 12a of the TMD layer 12), by forming the gate stack such that portions of the major surface of the channel layer 12' are exposed on either side of the gate stack.

Employing instead a direct wafer transfer approach (e.g. as shown in Fig. 3a-d or 4a-d) the interfacial layer will form a bottom layer of the layer stack and the TMD layer structure. The TMD layer structure may thus be used to form a back-gated TMD-channel device.

More specifically, a device may be formed by, after debonding the growth wafer from the layer stack, patterning the layer stack, the patterning comprising: patterning a channel layer in the TMD layer and patterning a gate stack in the dielectric layer and the interfacial layer, extending along the channel layer. Source/drain contacts may subsequently be formed in contact with the channel layer, e.g. contacting ends of the channel layer and/or the second major surface of the channel layer (i.e. corresponding to the second major surface of the TMD layer).

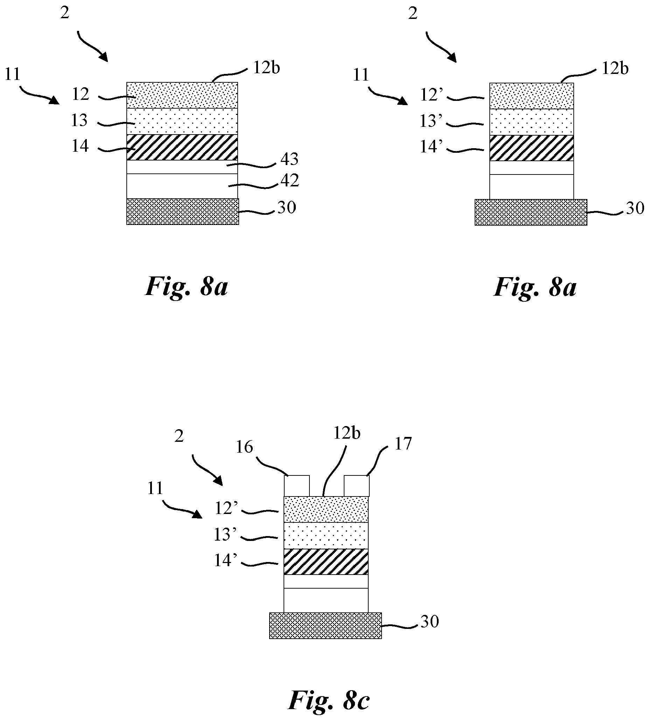

Fig. 8a-c illustrate an example method for forming a back-gated TMD-channel transistor device using a TMD layer structure formed using the direct wafer transfer approach, such as the TMD layer structure 2.

Fig. 8a shows the TMD layer structure 2 comprising the layer stack 11 bonded to the target wafer 30 with the ILD layer 14 facing the target wafer 30.

In Fig. 8b, the layer stack 11 has been patterned to define a channel layer 12' in the TMD layer, a gate dielectric layer 13' in the dielectric layer 13, and a gate layer 14' (sacrificial or metal) in the interfacial layer 14. A gate stack comprising the gate dielectric layer 13' and the gate layer 14' has thus been patterned in the layer stack 11, underneath the channel layer 12'. As described with reference to Fig. 7b, a sacrificial gate layer may be replaced with a final gate metal or electrode layer, e.g. after source/drain contact formation, using a replacement metal gate process.

In Fig. 8c, source and drain contacts 16, 17 have been formed in contact with the channel layer 12'. The source and drain contacts 16, 17 may as shown be formed as top contacts, contacting the second major surface of the channel layer 12' (i.e. corresponding to the second major surface 12b of the TMD layer 12).

The person skilled in the art realizes that the present invention by no means is limited to the examples described above. On the contrary, many modifications and variations are possible within the scope of the appended claims.

## Claims

1. A method for forming a transition metal dichalcogenide, TMD, layer structure (1) on a target wafer (30), the method comprising:
forming layer stack (11) on a growth wafer (10), comprising:
growing a transition metal dichalcogenide, TMD, layer (12) on a growth surface (10a) of the growth wafer (10), the TMD layer (12) having first and second opposing major surfaces (12a, 12b),
forming a dielectric layer (13) of a high-k dielectric material on the first major surface (12a) of the TMD layer (12), and
forming an interfacial layer (14) on a major surface (13a) of the dielectric layer (13), wherein the interfacial layer (13) is formed of a metal or a semiconductor, and is configured to induce stress at an interface between the growth wafer (10) and the TMD layer (12);
bonding the layer stack (11) to the target wafer (30); and
debonding the growth wafer (10) from the layer stack (11) using a mechanical debonding process wherein the growth wafer (10) is released from the TMD layer (12).

2. The method of claim 1, wherein the interfacial layer (14) is formed of Bi, Sb, Ni, Si, Ge or SiGe.

3. The method of any one of the preceding claims, wherein the growth wafer (10) is a sapphire wafer or a GaN wafer.

4. The method of any one of the preceding claims, wherein the interfacial layer (14) is formed with a thickness in a range of 10 nm or more, or 50 nm or more, and/or the dielectric layer (13) is formed with an equivalent oxide thickness of 5 nm or less, or 2 nm or less.

5. The method of any one of the preceding claims, comprising bonding the layer stack (11) to a carrier wafer (20, 120), with the interfacial layer (14) facing the carrier wafer (20, 120), and thereafter, in sequence: performing the debonding the growth wafer (10) from the layer stack (11), bonding the layer stack (11) to the target wafer (30) with the TMD layer (12) facing the target wafer (30), and debonding the carrier wafer (20, 120) from the layer stack (11).

6. The method of claim 5, wherein bonding the layer stack (11) to the carrier wafer (20, 120) comprises bonding the interfacial layer (14) of the layer stack (11) to the carrier wafer (20, 120) using a bonding layer stack (21, 121).

7. The method of any one of claims 1-4, comprising bonding the layer stack (11) to the target wafer (30), with the interfacial layer (14) facing the target wafer (30), and thereafter debonding the growth wafer (10) from the layer stack (11).

8. The method of claim 7, further comprising, after debonding the growth wafer (10) from the layer stack (11), forming a second dielectric layer (15) of a high-k dielectric material on the second major surface (12b) of the TMD layer (12), and optionally, forming a second interfacial layer (114a) on a major surface (15a) of the second dielectric layer (15).

9. The method of claim 8,
wherein the growth wafer (10) is a first growth wafer, the layer stack (10) is a first layer stack, the channel layer (12) is a first channel layer, the dielectric layer (13) is a first dielectric layer, and the interfacial layer (14) is a first interfacial layer;
wherein the second interfacial layer (114a) forms a first interfacial sub-layer (114a) on the major surface (15a) of the second dielectric layer (15),
and the method further comprises:
forming on a second growth wafer (110) a second layer stack (111), comprising:
growing a second TMD layer (112) on a growth surface of the second growth wafer (110), the second TMD layer (112) having first and second opposing major surfaces (112a, 112b),
forming a third dielectric layer (113) of a high-k dielectric material on the first major surface (112a) of the second TMD layer (112), and
forming a second interfacial sub-layer (114b) on a major surface of the third dielectric layer (113);
bonding the second layer stack (111) to the first layer stack (10) such that the first and second interfacial sub-layers (114a, 114b) are directly bonded to each other to form a common second interfacial layer (114) configured to induce stress at an interface between the second growth wafer (110) and the second TMD layer (112); and
thereafter debonding the second growth wafer (110) from the second layer stack (111) using a mechanical debonding process wherein the second growth wafer (110) is released from the second TMD layer (112).

10. The method of claim 9, further comprising, after debonding the second growth wafer (110) from the second layer stack (111), forming a fourth dielectric layer (215) of a high-k dielectric material on the second major surface (112b) of the second TMD layer (112), and optionally, forming a third interfacial layer (214a) on a major surface of the fourth dielectric layer (213).

11. The method of claim 10, wherein the third interfacial layer (214a) forms a third interfacial sub-layer (214a) on the major surface of the fourth dielectric layer (215), and the method further comprises:
forming on a third growth wafer (210) a third layer stack (211), comprising:
growing a third TMD layer (212) on a growth surface of the third growth wafer (211), the third TMD layer (212) having first and second opposing major surfaces (212a, 212b),
forming a fifth dielectric layer (213) of a high-k dielectric material on the first major surface (212a) of the second TMD layer (212), and
forming a fourth interfacial sub-layer (214b) on a major surface of the fifth dielectric layer (213);
bonding the third layer stack (211) to the second layer stack (111) such that the third and fourth interfacial sub-layers (214a, 214b) are directly bonded to each other to form a common third interfacial layer (214) configured to induce stress at an interface between the third growth wafer (210) and the third TMD layer (212); and
thereafter debonding the third growth wafer (210) from the third layer stack (211) using a mechanical debonding process wherein the third growth wafer (210) is released from the third TMD layer (212).

12. The method of claim 11, further comprising, after debonding the third growth wafer (210) from the third layer stack (211), forming a sixth dielectric layer (313) of a high-k dielectric material on the second major surface (212b) of the third TMD layer (212), and optionally, forming a fourth interfacial layer (314) on a major surface of the sixth dielectric layer (313).

13. The method of any one of claims 9-12, further comprising processing edges of the TMD layer structure (1), comprising at least the first layer stack (11) and the target wafer (30), using an edge bead removal process, and subsequently depositing the high-k dielectric material on the TMD layer structure (1) and along the processed edges.

14. A method for forming a TMD-channel device, comprising:
forming a TMD layer structure (1, 2) in accordance with the method of any one of claims 5-7; and
patterning the TMD layer structure (1, 2), the patterning comprising:
patterning a channel layer (12') in the TMD layer (12), and
patterning a gate stack (13', 14') in the dielectric layer (13) and the interfacial layer (14), the gate stack extending along the channel layer (12'); and forming source/drain contacts (16, 17) in contact with the channel layer (12').

15. The method according to claim 14, wherein, when dependent on claim 5, the gate stack (13', 14') is formed on top of the channel layer (12') and the source/drain contacts (16,17) are formed as side contacts or top contacts, or, when dependent on claim 7, the gate stack (13', 14') is formed underneath the channel layer (12') and the source/drain contacts (16,17) are formed as top contacts.
